# EUROPEAN PATENT APPLICATION

(11) **EP 1 052 062 A1**
(43) Date of publication of application: **15.11.2000**
(21) Application number: 00303717.3
(22) Date of filing: 03.05.2000
(51) Int. Cl.: B24B 37/04, B24B 53/007, B24D 3/00, H01L 21/304

(54) **Pré-conditioning fixed abrasive articles**

(30) Priority: 03.05.1999 US 132175 P
(71) Applicant: APPLIED MATERIALS, INC., Santa Clara, California 95054-3299 (US)
(72) Inventor: Tietz, James V., Fremont California 94536 (US); Li, Shijian, San Jose California 95129 (US); Birang, Manoocher, Los Gatos California 95033 (US); White, John M., Hayward California 94542 (US)
(74) Representative: Bayliss, Geoffrey Cyril

(57) **Abstract**

The disclosure relates to a method and apparatus for pre-conditioning a fixed abrasive article (100) comprising a plurality of projections (120a-120a-c) before initial use of the abrasive article for polishing a workpiece surface, comprising providing the fixed abrasive article in an initial, as manufactured, state comprising a plurality of spaced-apart abrasive particle-containing projections extending from the surface of a backing layer, the projections extending for different heights above the backing layer surface and having upper surfaces with different textures; and mechanically treating the projection to substantially equalize the heights of the projections and the textures of the upper surfaces thereof.

## Description

The present invention relates to methods for pre-conditioning fixed abrasive articles, such as fixed abrasive pads utilized for performing chemical-mechanical polishing (CMP), and fixed abrasive pads obtained thereby. The present invention has particular utility in the manufacture of semiconductor devices, e.g., high density integration devices.

Abrasive articles enjoy utility in a variety of industrial applications, e.g., for abrading, finishing, and polishing a variety of surfaces. Typical industrial uses of abrasive articles include polishing a substrate, as during various phases or steps in the manufacture of semiconductor devices, e.g., integrated circuit (IC) devices, and substrates for magnetic and/or magneto-optical (MO) information storage and retrieval media. As for the former application, in the course of manufacturing semiconductor devices from wafer substrates, the wafer typically undergoes numerous processing steps, including layer deposition, patterning, and layer removal, as by etching. After a number of various processing steps have been performed, it is necessary to achieve a high level or degree of surface planarity and uniformity in order to enable accurate further processing, e.g., photolithographic processing for patterning. A conventionally employed planarization technique comprises polishing, e.g., by chemical-mechanical polishing (CMP), wherein a wafer carrier assembly is moved relative to a polishing pad in a suitable CMP apparatus, as by translation, rotation, orbital motion, etc. The polishing pad is mounted on a movable, e.g., rotatable, turntable or platen driven by an external driving force means. The wafers are typically mounted on a carrier or polishing head which provides a controllable force, i.e., pressure, whereby the wafer(s) is (are) urged against the moving polishing pad. The CMP apparatus effects polishing or rubbing movement between the surface(s) of the semiconductor wafer(s) and the polishing pad while supplying and dispersing a fluid polishing slurry containing finely-dimensioned abrasive particles in a chemically active solution to simultaneously provide chemical activity and mechanical action on the wafer surface(s) while applying a force between the wafer(s) and the polishing pad. A similar process is used to produce in-laid metallization patterns in a dielectric layer.

Conventional polishing pads employed in abrasive slurry processing typically comprises a grooved porous polymeric surface, for example, of polyurethane. The particular abrasive slurry which is utilized is selected in accordance with the particular material(s) undergoing CMP. Essentially, the abrasive slurry impregnates the pad *via* the pores in the polymeric surface, while the grooves transport, and thus supply, the slurry to the wafer during CMP. A suitable polishing pad for use in CMP slurry processing as described *supra* is disclosed by Krywanczyk et al. in U.S. Pat 5,842,910. In practice, CMP is typically performed not only on the wafer (e.g., of silicon. Si) *per se*, but on variously constituted layers formed thereon, such as dielectric layers, and on surfaces comprising a combination of dielectric and conductive materials (e.g., as in damascene processing to form in-laid metallization patterns in a dielectric layer).

A distinctly different type of abrasive article, vis-à-vis the above-described abrasive slurry-type polishing pad, wherein the abrasive material is mobile relative to the pad, is a fixed abrasive article, e.g., a fixed abrasive polishing sheet or pad. Such fixed abrasive articles typically comprise a backing member having a plurality of geometrically shaped or configured abrasive elements adhered thereto. The abrasive elements in turn typically comprise a plurality of abrasive composite particles immobilized in a binder composed of, e.g., a polymeric material. During CMP employing a fixed abrasive sheet or pad, the workpiece, e.g., a semiconductor wafer, undergoing CMP wears away, i.e., erodes, the fixed abrasive elements, thereby releasing, i.e., mobilizing, the abrasive particles. Accordingly, during CMP employing a fixed abrasive sheet or pad, a chemical reagent (selected in relation to the particular material or materials undergoing CMP) is supplied to the workpiece surface to provide the requisite chemical activity, while the requisite mechanical action is provided by the fixed abrasive elements and the mobile abrasive particles released therefrom by erosion resulting from abrasion with the workpiece surface.

As a consequence of the above-described mechanism of operation, CMP processing performed with fixed abrasive pads or sheets do not require the use of a slurry containing loose, i.e., mobile, abrasive particles. A number of advantages accrue as a consequence of the use of fixed, i.e., immobilized, abrasive pads or sheets, including, *inter alia*, simplified effluent treatment, reduction in amount of consumable materials with attendant cost reduction, and reduced "dishing" compared to CMP performed with abrasive slurries.

Fixed abrasive articles suitable for use in CMP processing are disclosed by, for example, Rutherford et al. in U.S. Pat. 5,692,950; Calhoun in U.S. Pat 5,820,450; Haas et al in U.S. Pat. 5,453,312; and Hibbard et al. in U.S. Pat 5,454,844, the entire disclosures of which are incorporated herein by reference.

The fixed abrasive elements arc typically formed by filling recesses in an embossed, temporary carrier member with a slimy comprising a plurality of abrasive grains dispersed in a hardenable binder precursor, and then hardening the binder precursor to form individual abrasive composite elements which are laminated to a backing sheet, after which the embossed, temporary carder member is removed. Typically, the backing sheet containing the individual abrasive composite elements adhered thereto is then used in conjunction with a subpad containing a resilient element, with a rigid element interposed between the backing sheet and the resilient element. Such mounting can be effected by any of various types of laminating techniques, including the use of an adhesive inter-layer. Methods of forming a backing sheet having abrasive elements thereon are disclosed by Calhoun in U.S. Pat. 5,437,754, the entire disclosure of which is incorporated herein by reference, and by Rutherford et al. in U.S. Pat 5,692,950.

Fixed abrasive elements of conventional slurry-less type polishing pads are typically formed in various "positive" geometric configurations, such as cylindrical, cubical, truncated cylindrical, and truncated pyramidal shapes, as disclosed by Calhoun in U.S. Pat. 5,820,450. Conventional fixed abrasive articles also comprise "negative" abrasive elements, such as disclosed by Ravipati et al. in U.S. Pat. 5,014,468, the entire disclosure of which is incorporated herein by reference.

During CMP utilizing conventional polymeric-based polishing pads together with an abrasive slurry, the surface of the pads eventually becomes glazed, and thus non-receptive to accommodating and/or dispersing the abrasive slurry, and otherwise incapable of performing polishing at a satisfactory rate and with acceptable uniformity. Accordingly, conventional practices comprise periodically conditioning the pad surface so that it is maintained in a proper state for effectively performing CMP. Conventional conditioning practices typically utilize a very hard and rough, e.g., diamond or silicon carbide (SiC)-based conditioning disk, which functions by shredding and roughening the pad surface either during or between wafer passes. However, after repeated conditioning operations, the pad and the disk are eventually consumed and incapable of performing polishing at a satisfactory rate with acceptable uniformity. When this state is obtained, the polishing pad and/or disk must be replaced, during which time the CMP apparatus is unavailable for use in polishing, with an attendant loss in workpiece throughput.

By contrast, fixed adhesive pads do not incur the same type of adverse smoothing or glazing as do conventional polymeric pads utilized with abrasive slurries. This characteristic of fixed adhesive pads occurs because the abrasive particles are carried in a binder inside the material that is brought into contact with the wafer surface. Therefore, there is no need to roughen the surface to enhance the transport of the particles to the wafer surface. Further, whereas periodic or pre-conditioning of polymeric-based pads is useful, periodic or pre-conditioning of fixed abrasive pads in a similar (i.e., roughening) fashion would be expected to adversely affect the polishing rate and uniformity stability, i.e., wafer-to-wafer uniformity. Consequently, conventional practices with fixed abrasive pads do not involve either pre-conditioning prior to initial CMP, or periodic conditioning after initial CMP.

However, given the current state of the art of fixed abrasive manufacturing, CMP utilizing fixed abrasive pads or sheets disadvantageously exhibits the "first wafer(s) effect", involving unstable removal ate and uniformity of polishing of the initial, i.e., first, wafer(s) treated with a fresh pad or sheet.

Thus, there exists a need for methodologies for conditioning the top surface of a fixed abrasive article, e.g., a polishing pad or sheet, so as to create a uniform, consistent surface substantially similar to a surface which would be produced by successively polishing many wafers on that same pad or sheet area, the goal being to provide high wafer-to-wafer polishing rate stability and eliminate, or at least minimize, the "first wafer(s) effect" wherein non-uniformity of polishing occurs with the initial (i.e., "first") wafer(s) polished by a fresh pad or sheet, which methodologies are fully compatible with the economic and throughput requirements of large-scale automated CMP processing.

The present invention addresses and solves problems attendant upon the use of fixed abrasive articles, such as pads and/or sheets, for performing CMP processing, e.g., in the manufacture of semiconductor wafer-based integrated circuit (IC) devices, and is fully compatible with all other mechanical and chemical aspects of CMP processing for polishing and/or planarization.

An aspect of the present invention is a method of pre-conditioning a fixed abrasive article comprising a plurality of projections, before initial use in polishing a surface of a workpiece, said method comprising the steps of:
providing a fixed abrasive article in an initial state comprising a plurality of spaced-apart projections extending from a surface of a backing layer, the projections extending for different heights above the surface of the backing layer and having upper surfaces with different textures; and
treating the projections to substantially equalize the heights of the projections and the textures of the upper surfaces thereof.

Another aspect of the invention is an apparatus for pre-conditioning a fixed abrasive article comprising a plurality of projection, before initial use in polishing a surface of a workpiece, the fixed abrasive article being in an initial state comprising a plurality of spaced-apart projections extending from a surface of a backing layer, the projections extending for different heights above the surface of the backing layer. The apparatus comprises a platen for mounting and rotating the article, a conditioning disk, and a conditioning head for mounting and moving the conditioning disk and for urging the conditioning disk against the projections. The apparatus also includes a pivot arm far moving the conditioning head to effect relative movement between the conditioning disk and the article to substantially equalize the heights of the projections.

Additional aspects of the invention will become readily apparent to those skilled in the art from the following detailed description, wherein various aspects of the invention are shown and described to illustrate the invention. As will be realized, the invention is capable of other and different embodiments, and its several details are capable of modifications in various obvious respects, all without departing from the invention. Accordingly, the drawings and description are to be regarded as illustrative in nature, and not as restrictive.

The following detailed description of an embodiment of the present invention can best be understood when read in conjunction with the following drawings, wherein:
FIG. 1 illustrates, in schematic cross-sectional view, a portion of a fixed abrasive element in an initial, as manufactured state; and
FIG. 2 illustrates, in schematic cross-sectional view, the portion of to fixed abrasive element of FIG. 1 after pre-conditioning treatment to equalize the heights and surface textures of projections forming the abrasive elements.
FIG. 3 is a perspective view of an apparatus according to an embodiment of the present invention.
FIG. 4 is a perspective view of an apparatus according to another embodiment of the present invention.

The present invention includes methods of pre-conditioning a fixed abrasive article comprising a plurality of projections, before initial use in polishing a surface of a workpiece, by providing a fixed abrasive article in an initial state comprising a plurality of spaced-apart projections having upper surfaces with different textures and extending from a surface of a backing layer, the projections extending for different heights above the surface of the backing layer; and performing treatment of the projections to substantially equalize the textures of the upper surfaces and the heights of the projections.

Embodiments of the present invention include physically dressing the fixed abrasive article, as with an abrasive material which is at least as hard as the abrasive material of the projections, and pro-seeding the fixed abrasive articles with a slurry.

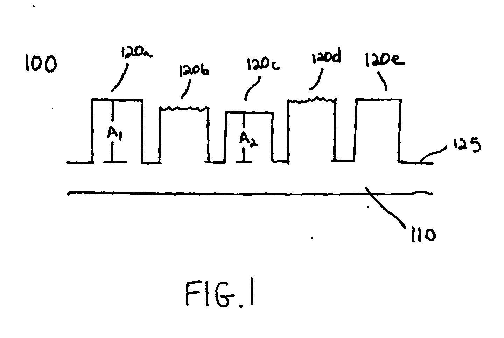

With reference to Fig. 1, a conventional fixed abrasive article 100, such as a fixed abrasive polishing sheet or pad, is shown in its initial state, i.e., as supplied by the manufacturer and before use in polishing a surface of a workpiece. Fixed abrasive article 100 includes backing layer 110. A plurality of spaced apart projections 120a-120e, in the form of cylindrically shaped posts (appearing rectangular in cross-section), extend from a surface 125 of backing layer 110. With continued reference to Fig. 1, projection 120a extends for height A1 above the surface of the backing layer, while projection 120c extends for height A2 above the surface of the backing layer. Further, the texture of the upper surface of projection 120a is significantly rougher than that of the upper surface of projection 120b. These height and surface texture differences disadvantageously result in the "first wafer effect", involving non-uniform polishing of the initial, i.e., first, wafer treated with a fresh pad or shed.

In embodiments of the present invention, the projections 120a-120e are treated, such as by mechanical treatment, to substantially equalize the textures of the upper surfaces of the projections and the heights of the projections. By way of illustration, but not limitation, the mechanical treatment may comprise urging a relatively smooth-surfaced abrasive disk or pad against the projections and effecting relative movement between the disk and the article. The abrasive disk or pad can comprise a material having a surface roughness ≤ 0.20 µm, such as silicon carbide, alumina, silica, titania, copper, resist, and polymers. The fixed abrasive article can comprise a plurality of geometrically shaped or configured abrasive elements adhered to said backing member and each of the plurality of abrasive elements can, as is known, comprise a plurality of abrasive particles immobilized in a binder, such as a polymeric material.

In further embodiments of the present invention, the mechanical treatment can comprise using a conditioning pad or disk and an abrasive slurry in place of the abrasive disk. The abrasive slurry can comprise abrasive particles selected from the group consisting of silicon carbide, alumina, silica, and titania.

In other embodiments of the present invention, the mechanical treatment comprises using a conditioning pad or disk and a conditioning liquid, wherein urging of the conditioning pad against the projections generates debris which aids the mechanical treatment.

A CMP system suitable for use in the practice of the present invention and comprising a CMP apparatus and its associated conditioning device, is described in U.S. Pat 5,738,574, the entire disclosure of which is incorporated herein.

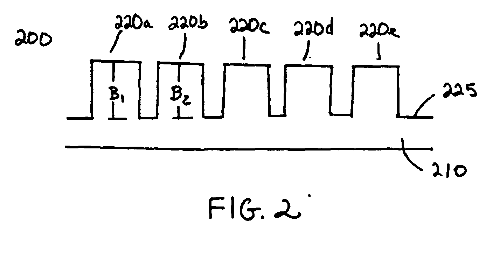

Fig. 2 illustrates a fixed abrasive article 200, such as a fixed abrasive polishing sheet or pad, prepared in accordance with the inventive methodology. Fixed abrasive article 200 comprises a backing layer 220 having a surface 225, and a plurality of spaced-apart, geometrically-shaped or configured projections 220a-220e extending from the surface 225 of the backing member 220, said plurality of projections comprising a plurality of abrasive elements having upper surfaces with substantially equal textures and extending for a substantially equal height (B1 and B2) from the surface 225 of the backing layer 220.

According to the invention, the particular geometric shape or configuration of the projections of fixed abrasive article 200 is not limited to to illustrated parallelepiped shape but rather a variety of geometrical shapes or configurations can be utilized for to projections comprising the abrasive elements adhered to to backing member. Further, each of the plurality of projections forming the abrasive elements includes a plurality of abrasive particles, such as silicon carbide, silica, alumina and titania, immobilized in a binder, such as a binder comprised of a polymeric material.

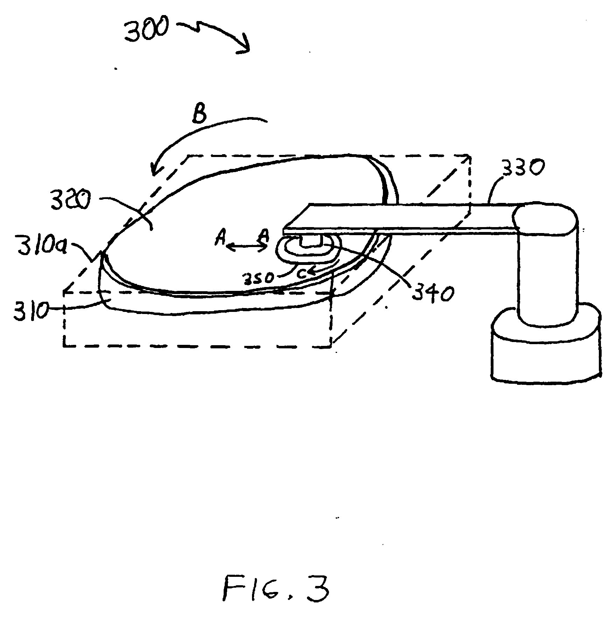

Fig. 3 illustrates an apparatus 300 according to an embodiment of the present invention, comprising a conventional rotatable platen 310 for mounting a fixed abrasive article 320 to be conditioned. As discussed above, fixed abrasive article 320 comprises abrasive projections having different heights and upper-surface textures adhered to a backing member and immobilized in a polymeric binder. Platen 310 can be round or can be a square web 310a, as shown by the dotted lines, according to the shape of the abrasive article to be conditioned. Apparatus 300 further comprises a pivot arm 330, a holder or conditioning head 340 mounted to one end of pivot arm 330, and an abrasive disk 350 mounted to the underside of conditioning head 340. As discussed above, abrasive disk 350 can comprise a material having a roughness ≤ 0.20µm, such as silicon carbide, alumina, silica, titania, copper, resist, and polymers. Pivot arm 330 is operatively coupled to platen 310, and maintains conditioning head 340 and abrasive disk 350 against abrasive article 320. Typically, apparatus 300 is part of a chemical-mechanical polishing system and may comprise, for example, a chemical-mechanical polishing machine having a polishing head adapted to press a wafer against the abrasive article 320 to polish the wafer.

In operation, abrasive article 320 is placed on platen 310 or 310a, and abrasive disk 350 is placed on conditioning head 340. Platen 310, 310a rotates as indicated by arrow B, and conditioning head 340 rotates as indicated by arrow C to scan a circular zone of abrasive article 320 to substantially equalize the textures and heights of the upper surfaces of the projections of abrasive article 320, as discussed above. Optionally, pivot arm 330 scans back and forth across platen 310 as indicated by arrows A.

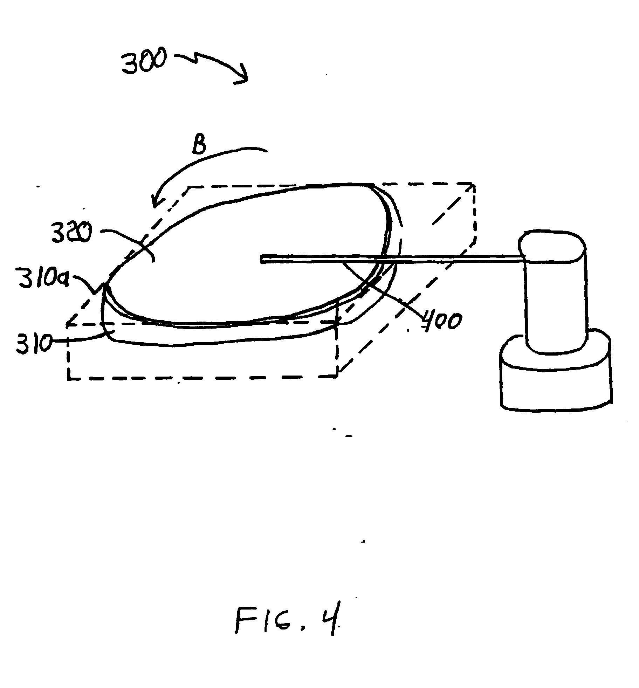

Alternately, as shown in Figure 4, apparatus 300 may include a rod 400 or similar elongated structural element extending from roughly from a center of the abrasive article 320 on the platen 310 to at least an outer diameter of the abrasive article 320. The rod 400 includes, on a surface corresponding to the abrasive article 320, a material having a roughness ≤ 0.20µm 320, such as silicon carbide, alumina, silica, copper, resist, and polymers. In operation, the rod is pressed against the abrasive article to condition the abrasive article 320 as the platen 310 rotates.

In the previous description, numerous specific details are set forth, such as specific materials, structures, processes, etc., in order to provide a better understanding of the present invention. However, the present invention can be practiced without resorting to the details specifically set forth. In other instances, well known processing materials and techniques have not been described in detail in order not to unnecessarily obscure the present invention.

Only the preferred embodiments of the present invention and but a few examples of its versatility are shown and described in the present disclosure. It is to be understood that the present invention is capable of use in various other combinations and environments and is susceptible to changes and/or modifications within the scope of the inventive concept as expressed herein.

## Claims

1. A method of pre-conditioning a fixed abrasive article comprising a plurality of projections, before initial use in polishing a surface of a workpiece, said method comprising the steps of:
providing a fixed abrasive article in an initial state comprising a plurality of spaced-apart projections extending from a surface of a backing layer, said projections extending for different heights above said surface of said backing layer, and
treating said projections to substantially equalize said heights of said projections.

2. The method of claim 1, wherein said projections have upper surfaces with different textures and said step of treating said projections further comprises substantially equalizing said textures.

3. The method of claim 1, wherein said projections are in the form of cylindrically-shaped posts.

4. The method of claim 1, wherein said treatment is mechanical treatment

5. The method of claim 3, wherein said mechanical treatment comprises urging a conditioning pad or disk against said projections and effecting relative movement between said disk and said article.

6. The method of claim 5, wherein said conditioning pad or disk comprises a material having a roughness ≤ 0.20 µm.

7. The method of claim 6, wherein said material of said conditioning pad or disk is selected from the group consisting of silicon carbide, alumina, silica, titania, copper, resist and polymers.

8. The method of claim 4, wherein said mechanical treatment comprises urging a conditioning pad or disk and an abrasive slurry against said projections and effecting relative movement therebetween.

9. The method of claim 8, wherein said abrasive slurry comprises abrasive particles selected from the group consisting of silicon carbide, alumina, silica, and titania.

10. The method of claim 4, wherein said mechanical treatment comprises using a conditioning pad or sheet and a conditioning liquid and urging said conditioning pad or sheet against said projections with relative movement therebetween to generate debris which aids said mechanical treatment.

11. The method of claim 1, wherein said fixed abrasive article is a fixed abrasive polishing sheet or pad.

12. The method of claim 1, wherein said fixed abrasive article comprises a plurality of geometrically-shaped or configured abrasive elements adhered to said backing member.

13. The method of claim 10, wherein each of said plurality of abrasive elements comprises a plurality of abrasive particles immobilized in a binder.

14. The method of claim 13, wherein said binder comprises a polymeric material.

15. A method of pre-conditioning a fixed abrasive article comprising a plurality of spaced-apart projections adhered to and extending from a surface of a backing member, before initial use of said abrasive article in polishing a workpiece surface, said method comprising the steps of:
providing a fixed abrasive article in an initial state wherein said plurality of projections extend for different heights above said backing member surface; and
mechanically treating said projections to substantially equalize said heights of said projections.

16. The method of claim 15, wherein said projections have upper surfaces with different textures and said step of mechanically treating said projections further comprises substantially equalizing said textures.

17. The method of claim 16, wherein said fixed abrasive article is a fixed abrasive polishing pad or sheet comprised of a plurality of geometrically-shaped or configured abrasive elements adhered to said surface of said backing member.

18. The method of claim 17, wherein each of said abrasive elements comprises a plurality of abrasive particles immobilized in a polymeric binder.

19. A method of pre-conditioning a fixed abrasive article comprising a plurality of abrasive elements in the form of spaced-apart projections adhered to and extending from a surface of a backing member, before initial use of said abrasive article in polishing a workpiece surface, said method comprising the steps of:
providing a fixed abrasive article in the form of a polishing pad or sheet in an initial state, wherein said plurality of abrasive elements in the form of spaced-apart projections comprise a plurality of cylindrically-shaped posts adhered to and extending for different heights above said surface of said backing member, each of said abrasive elements comprising a plurality of abrasive particles immobilized in a polymeric binder; and
mechanically treating said projections to substantially equalize said heights of said cylindrically-shaped posts.

20. The method of claim 19, wherein said posts have upper surfaces with different textures and said step of mechanically treating said projections further comprises substantially equalizing said textures.

21. An apparatus for pre-conditioning a fixed abrasive article comprising a plurality of projections, before initial use in polishing a surface of a workpiece, the fixed abrasive article being in an initial state comprising a plurality of spaced-apart projections extending from a surface of a backing layer, said projections extending for different heights above said surface of said backing layer, the apparatus comprising:
a platen for mounting and rotating the article;
a conditioning disk;
a conditioning head for mounting and moving the conditioning disk and for urging the conditioning disk against the projections; and
a pivot arm for moving the conditioning head to effect relative movement between the conditioning disk and the article to substantially equalize said heights of said projections.

22. The apparatus of claim 21, wherein said projections have upper surfaces with different textures and the relative movement between the conditioning disk and the article is further for substantially equalizing said textures.

23. The apparatus of claim 21, wherein the conditioning disk comprises a material having a roughness ≤ 0.20 µm.

24. The apparatus of claim 23, wherein the material of the conditioning disk is selected from the group consisting of silicon carbide, alumina, silica, titania, copper, resist, and polymers.

25. The apparatus of claim 21, wherein the pivot arm is for scanning the conditioning disk such that the relative movement between the conditioning disk and the article comprises a scanned circular zone of the article.

26. The apparatus of claim 21, wherein the apparatus comprises a chemical-mechanical polishing machine.
